# EUROPEAN PATENT SPECIFICATION

(11) **EP 2 594 662 B1**
(45) Date of publication and mention of the grant of the patent: **09.04.2014**
(21) Application number: 11189954.8
(22) Date of filing: 21.11.2011
(51) Int. Cl.: C23F 1/18, C23F 1/46, C23F 1/44, H05K 3/06, H05K 3/10, H01L 21/3213

(54) **Aqueous composition for etching of copper and copper alloys**
Wässrige Zusammensetzung zur Ätzung von Kupfer und Kupferlegierungen
Composition aqueuse pour gravure du cuivre et des alliages de cuivre

(43) Date of publication of application: 22.05.2013
(73) Proprietor: Atotech Deutschland GmbH, 10553 Berlin (DE)
(72) Inventor: Lützow, Dr. Norbert, 12205 Berlin (DE); Thoms, Martin, 13156 Berlin (DE); Exner, Anika, 10365 Berlin (DE); Kloppisch, Mirko, 10245 Berlin (DE)
(74) Representative: Wonnemann, Jörg

(56) References cited:
- EP-A1- 1 978 134
- EP-A1- 2 253 740
- KR-A- 20090 090 456
- US-A1- 2002 182 434

## Description

### Field of the Invention

The invention relates to aqueous compositions for etching of copper and copper alloys and a process for etching of copper and copper alloys in the manufacture of printed circuit boards, IC substrates, copperised semiconductor wafers and the like.

### Background of the Invention

Circuit formation by etching of copper or copper alloy layers is a standard manufacturing step in production of printed circuit boards, IC substrates and related devices.

A negative pattern of the circuit is formed by a) applying an etch resist, e.g., a polymeric dry film resist or a metal resist on a layer of copper, b) etching away those portions of copper not covered by the etch resist and c) remove the etch resist from the remaining copper circuit.

Etching solutions applied for this task are selected from different types of compositions such as mixtures of an oxidizing agent and an acid. Two main types of etching solutions are based on an acid such as sulphuric acid or hydrochloric acid and contain as the oxidizing agent either hydrogen peroxide or Fe³⁺ ions added as FeCl₃. Such etching solutions are disclosed in C. F. Coombs, Jr., "Printed Circuits Handbook", 5th Ed. 2001, Chapter 33.4.3, pages 33.14 to 33.15 and Chapter 33.4.5, pages 33.17.

The ongoing miniaturization of circuits in terms of line width / interline-space values and thickness of the copper layers to be etched does not allow to use conventional etching solutions such as the ones described above.

The disadvantage of known etching solutions is even more present if the copper tracks are manufactured by a semi additive process (SAP). Here the bare dielectric substrate is first coated with a seed layer serving as an electrically conductive layer. The seed layer comprises for example copper deposited by electroless plating. Next, a patterned resist layer is formed on the seed layer and a thicker, second copper layer is deposited by electroplating into the openings of the patterned resist layer onto the seed layer. The patterned resist layer is stripped and the seed layer in between copper tracks deposited by electroplating needs to be removed by a differential etch step. The seed layer deposited by electroless plating has a finer grain structure than the second copper layer deposited by electroplating. The different grain structures can lead to a different etching behaviour of the individual copper layers.

A similar situation is present when copper tracks are manufactured by a modified semiadditive process (m-SAP) wherein a thick, second copper layer is deposited in the openings of the patterned resist layer onto a first thin layer of copper. The first copper layer is manufactured, e.g. by thinning a copper clad attached to the dielectric substrate. Again, both first and second copper layer have a different grain structure.

The etching solution applied for the differential etching step should only remove the first copper layer in between the copper tracks while not attacking the sidewalls and the top of the copper tracks deposited by electroplating and the underlying first copper layer or copper seed layer.

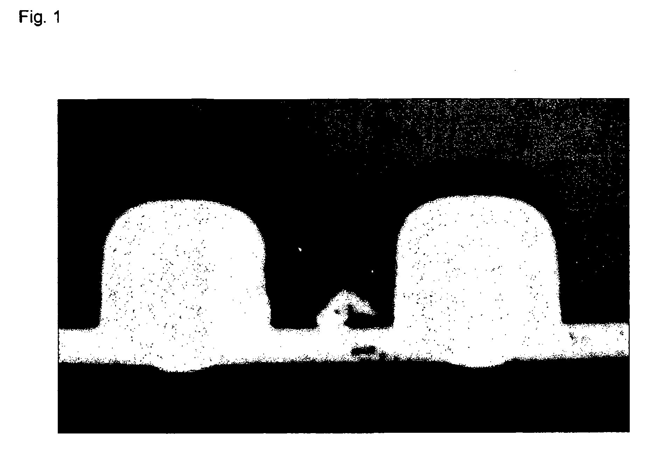

Etching solutions based on sulfuric acid and hydrogen peroxide lead to an undesired undercutting of the first copper layer during etching (Fig. 1) which results in an insufficient adhesion of the copper layer on the dielectric substrate.

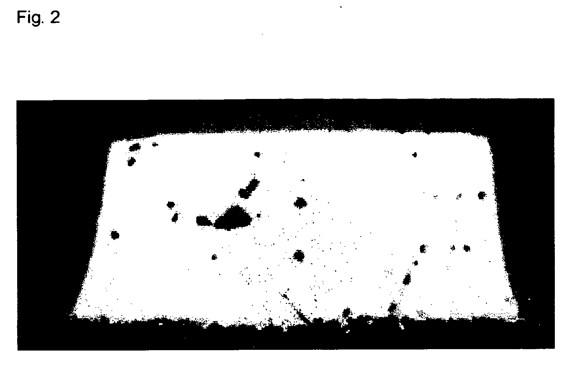

Etching solutions based on sulfuric acid and Fe³⁺ ions typically show an etching behaviour as shown in Fig. 2. The broader base of the etched copper line can lead to circuit shorts which are not acceptable.

An iron-chloride based solution for copper etching suitable for the semi additive process is disclosed in US 2002/0182434 A1. A disadvantage of iron-chloride based etchants is the undesired formation of chlorine gas during electrolytic regeneration of said etching solution.

### Objective of the present Invention

Therefore, it is the first objective of the present invention to provide an aqueous composition for etching of copper and copper alloys which results in the formation of rectangular shaped copper features after etching.

It is a second objective of the present invention to remove Cu²⁺ ions from said aqueous composition.

### Summary of the Invention

The first objective is solved by an aqueous composition for etching of copper and copper alloys, the composition comprising Fe³⁺ ions, at least one acid and at least one etching additive selected from the group consisting of N-alkoxylated polyamides obtained by a) N-alkoxylation of a polyamide with one or more compounds of formula (1), 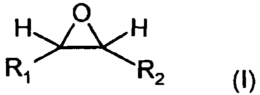 wherein R₁ is hydrogen or a hydrocarbon residue with 1 to 6 carbon atoms and R₂ is hydrogen or a hydrocarbon residue with 1 to 6 carbon atoms
and/or b) obtained by polymerization of a N-alkoxylated lactam.

A rectangular line shape of etched copper or copper alloy structures is achieved when applying the aqueous composition of the present invention. Thereby, the risk of circuit shorts between individual copper or copper alloy structures is minimized. Furthermore, a sufficient adhesion between the etched copper or copper alloy structure and the underlying dielectric substrate is achieved.

The second objective of the present invention is solved by a process for etching of copper and copper alloys comprising, in this order, the steps of
a. providing a substrate having a copper or copper alloy surface,
b. contacting said substrate with the aqueous composition according to the present invention in a first tank
   wherein during contacting copper is oxidized to Cu²⁺ ions and the Cu²⁺ ions are disclosed in the aqueous composition according to the present invention,
c. transferring a portion of the aqueous composition according to the present invention after contacting with the substrate to a second tank wherein said second tank comprises an anode and a cathode and
d. reducing said Cu²⁺ ions to copper by applying a current between said anode and said cathode.

### Brief Description of the Figures

Figure 1 shows two copper tracks obtained by etching with an aqueous composition consisting of sulfuric acid and hydrogen peroxide (comparative example).
Figure 2 shows a copper track obtained by etching with an aqueous composition consisting of sulfuric acid and Fe³⁺ ions (comparative example).
Figure 3 shows two copper tracks obtained by etching with an aqueous composition according to the present invention.

### Detailed Description of the Invention

A layer of copper or a copper alloy is etched with an aqueous composition for etching of copper and copper alloys, the composition comprising Fe³⁺ ions, at least one acid and at least one etching additive selected from the group consisting of N-alkoxylated polyamides, obtained by a) N-alkoxylation of a polyamide with one or more compounds of formula (1), 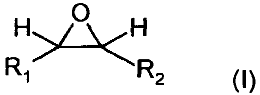 wherein R₁ is hydrogen or a hydrocarbon residue with 1 to 6 carbon atoms and R₂ is hydrogen or a hydrocarbon residue with 1 to 6 carbon atoms
and/or b) obtained by polymerization of a N-alkoxylated lactam.

Preferably, R1 and R2 in compounds according to formula (I) are preferably hydrogen and methyl. Most preferably R1 and R 2 are hydrogen.

The N-alkoxylated lactam is selected from compounds according to formula (II): 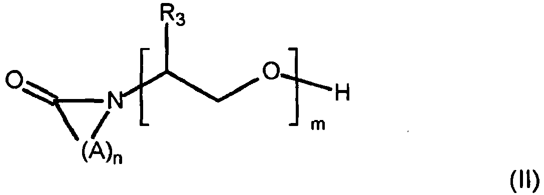 wherein R3 is hydrogen or methyl,
A is a hydrocarbon residue,
n is a whole number from 2 to 10, more preferably from 2 to 5,
and m is a whole number from 1 to 50, more preferably from 1 to 12.

The hydrocarbon residue A is preferably a —CH₂— group.

Preferably, the N-alkoxylated lactam according to formula (II) is selected from the group consisting of ethoxylated beta-lactam, hexaethoxylated gamma-butyrolactam, octaethoxylated delta-valerolactam, pentapropoxylated delta-valerolactam, hexaethoxylated epsilon-caprolactam and dodecaethoxylated epsilon-caprolactam.

The at least one etching additive obtained by N-alkoxylation of a polyamide with one or more compounds of formula (I) is a N-alkoxylated polyamide. Such polymers can be for example obtained by swelling the polyamine in an alkyleneoxide compound according to formula (I) at a temperature in the range of 10 to 40 °C followed by addition of further alkyleneoxide compound according to formula (I) at a temperature in the range of 100 to 160 °C. A detailed description of the synthesis method is disclosed in DE 913 957.

N-alkoxylated polyamides are obtainable by a ring-opening polymerization reaction of monomers according to formula (II) at for example 260 °C in an inert atmosphere of nitrogen for about 4 to 5 hours.

The concentration of the at least one etching additive in the aqueous composition ranges from 0.001 to 10 g/l, more preferred from 0.005 to 5 g/l and most preferred from 0.01 to 1 g/I.

The source for Fe³⁺ ions is selected from water soluble salts of Fe³⁺ ions. The most preferred source of Fe³⁺ ions is Fe₂(SO₄)₃.

The concentration of Fe³⁺ ions ranges from 1 to 100 g/I, more preferred from 1 to 50 g/I and most preferred from 5 to 40 g/I.

The at least one acid is selected from the group comprising mineral acids such as sulfuric acid, and organic acids such as methanesulfonic acid. The most preferred acids are sulfuric acid and methanesulfonic acid.

The concentration of the acid (or all acids together in case more than one acid is added) ranges from 10 to 400 g/I, more preferably from 30 to 300 g/I and most preferably from 50 to 200 g/I.

Optionally, the aqueous composition further contains one or more of Fe²⁺ ions, surfactants, a corrosion inhibitor selected from triazoles, benzotriazoles, imidazoles, benzimidazole, tetrazoles and isocyanates, organic sulfur compounds such as thiourea and sulfosalicylic acid and polyalkylene compounds such as polyethylene glycol, polypropylene glycol, copolymers of polyethylene glycol and polypropylene glycol and derivates thereof.

The substrates are preferably treated by spraying the aqueous composition according to the invention onto the substrates. The aqueous composition can be sprayed in a vertical mode or horizontal mode, depending on the equipment desired. Alternatively, the substrates can be immersed into the aqueous composition by dipping.

The temperature of the aqueous composition according to the present invention during use ranges from 10 to 60 °C, more preferably from 20 to 50 °C and most preferably from 30 to 45 °C. The contact time depends on the copper thickness to be etched and is in the range from 10 to 360 s, more preferably from 20 to 200 s and most preferably from 30 to 90 s.

During use the aqueous composition is enriched in Cu²⁺ ions. At the same time Fe³⁺ ions are reduced to Fe²⁺ ions. Cu²⁺ ions have a negative impact on the performance of the aqueous composition. Cu²⁺ ions increase the density and viscosity of the etching solution and thereby negatively effect the etch behaviour. The etch rate and side wall etching performance is for example decreased. Furthermore, precipitation of Cu²⁺ ion complexes can occur. Such precipitates pose a mechanical danger to the equipment and the surfaces coming into contact with the aqueous composition.

In processes according to prior art some or all of the added Cu²⁺ ions are removed by bleeding (removing) an adequate amount of etching solution and adding (feeding) fresh etching solution to the remaining solution.

One particular method to remove Cu²⁺ ions from an aqueous solution is to electrolytically reduce Cu²⁺ ions to metallic copper.

In principle, a second tank equipped with an anode and a cathode and a rectifier is required for electrolysis.

Portions of the aqueous composition according to the present invention are transferred from a first tank where or from which the etching of copper or a copper alloy layer is performed to a second tank equipped for electrolysis. During electrolysis Cu²⁺ ions are cathodically reduced to metallic copper and at the same time Fe²⁺ ions are oxidised anodically to Fe³⁺ ions.

The metallic copper can be collected and recycled. Without an electrolytic regeneration cell the oxidizing agent (Fe³⁺ ions) would need to be continuously added to the etching solution. By the application of the above described regeneration the spent Fe³⁺ ions are regenerated at the anodes (Fe²⁺ is oxidised to Fe³⁺) and thereby no adding (feeding) of the oxidising agent during use of the etching solution is required.

Halogenide ions are not preferred in the aqueous composition when used in the process according to the present invention because they are oxidized during the electrolysis reaction and thereby elemental dihalogene molecules are formed.

A method and an apparatus useful for this process are disclosed in US 2006/0175204 A1. This method involves feeding of the etching solution into an electrolysis cell being hermetically sealed or having an anode hood, the electrolysis cell comprising a cathode, an inert anode, means for removing the electrolytically deposited copper from the cathode and means for collecting the removed copper and applying a potential to the removed copper, wherein the electrolysis cell does not have an ion exchange membrane or a diaphragm.

### Examples

The invention will now be illustrated by reference to the following non-limiting examples.

A substrate containing a dielectric layer, a seed layer obtained by electroless plating of copper and a patterned second layer of copper obtained by electroplating was used throughout all examples.

The seed layer not covered by the patterned second layer of copper was etched away by spraying different aqueous compositions with an adjusted etch rate of 2 µm/min onto the substrates. The contact time was adjusted to provide the required copper removal. The samples were rinsed with water and the dry film resist was stripped.

The obtained line shapes of the etched copper tracks were investigated from cross-sections by optical microscope after depositing a nickel layer onto the copper tracks which serves as a protection layer during preparation of the cross-sections.

### Example 1 (comparative)

An aqueous composition consisting of 20 g/l H₂O₂ and 90 g/I sulfuric acid was applied as etching solution.

The resulting line shape of copper tracks (track width: 8 µm, track height: 10 µm) is shown in Fig. 1. The copper tracks show a severe undercutting of the track base (i.e. the seed layer obtained by electroless plating of copper). Hence, the copper track has not the required rectangular shape and no sufficient adhesion to the underlying dielectric substrate.

### Example 2 (comparative)

An aqueous composition consisting of 5 g/l Fe₂(SO₄)₃ and 90 g/I sulfuric acid was applied as etching solution.

The resulting line shape of the copper tracks (track width: 20 µm, track height: 10 µm) is shown in Fig. 2. The copper track shows a strong trapezoidal shape. Hence, the copper track does not provide the desired rectangular shape and poses the danger of circuit shorts or cross-talk between individual tracks.

### Example 3

An aqueous composition consisting of 15 g/l Fe₂(S0₄)₃, 90 g/I sulfuric acid and 0.1 g/l of a N-ethoxylated Polyamide 6, obtained by a ring-opening polymerization of ε-caprolactam-N-ethoxylate was applied as etching solution.

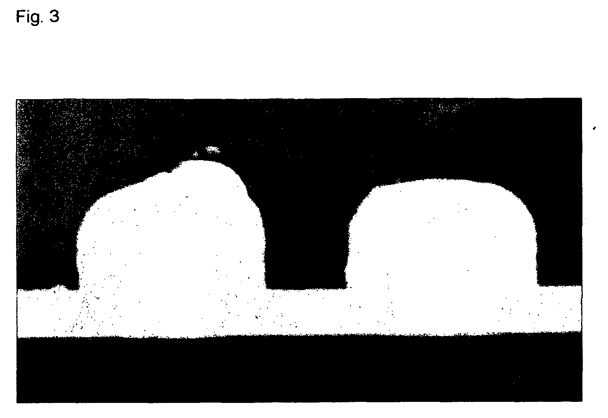

The resulting line shape of the copper tracks (track width: 8 µm, track height: 10 µm) is shown in Fig. 3. The copper tracks have the desired rectangular line shape, have a sufficient adhesion to the underlying dielectric substrate and pose no risk for circuit shorts.

## Claims

1. An aqueous composition for etching of copper and copper alloys comprising Fe³⁺ ions, at least one acid and at least one etching additive selected from N-alkoxylated polyamides
wherein the concentration of Fe³⁺ ions ranges from 1 to 100 g/I, the concentration of the at least one acid ranges from 10 to 400 g/I and the concentration of the at least one etching additive ranges from 0.001 to 10 g/l.

2. The aqueous composition for etching of copper and copper alloys according to claim 1 wherein the N-alkoxylated polyamide is obtained by N-alkoxylation of a polyamide with one or more compounds of formula (1), 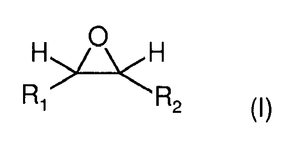 wherein R₁ is hydrogen or a hydrocarbon residue with 1 to 6 carbon atoms and R₂ is hydrogen or a hydrocarbon residue with 1 to 6 carbon atoms.

3. The aqueous composition for etching of copper and copper alloys according to claim 1 wherein R1 and R2 in formula (I) are selected from hydrogen and methyl.

4. The aqueous composition for etching of copper and copper alloys according to claim 1 wherein the N-alkoxylated polyamide is obtained by polymerization of a N-alkoxylated lactam according to formula (2) 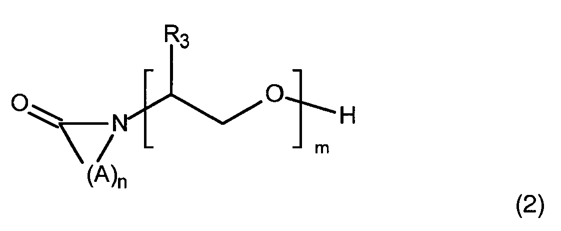 wherein R3 is selected from the group consisting of hydrogen and methyl,
A is a hydrocarbon residue,
n is a whole number from 2 to 10 and m is a whole number from 1 to 50.

5. The aqueous composition for etching of copper and copper alloys according to claim 4 wherein the N-alkoxylated lactam according to formula (II) is selected from the group consisting of ethoxylated beta-lactam, hexaethoxylated gamma-butyrolactam, octaethoxylated delta-valerolactam, pentapropoxylated delta-valerolactam, hexaethoxylated epsilon-caprolactam and dodecaethoxylated epsilon-caprolactam.

6. The aqueous composition for etching of copper and copper alloys according to any of the foregoing claims wherein the at least one acid is selected from the group comprising sulfuric acid and methanesulfonic acid.

7. A process for etching of copper and copper alloys comprising, in this order, the steps of
a. providing a substrate having a copper or copper alloy surface,
b. contacting said substrate with the aqueous composition according to any of claims 1 to 9 in a first tank
wherein during contacting copper is oxidized to Cu²⁺ ions and the Cu²⁺ ions are disclosed in said aqueous composition,
c. transferring a portion of said aqueous composition after contacting with the substrate to a second tank
wherein said second tank comprises an anode and a cathode and
d. reducing said Cu²⁺ ions to copper by applying a current between said anode and said cathode.

## Patentansprüche

1. Wässrige Zusammensetzung zum Ätzen von Kupfer und Kupferlegierungen, umfassend Fe³⁺-Ionen, mindestens eine Säure und mindestens ein Ätzadditiv, das aus N-alkoxylierten Polyamiden ausgewählt ist,
wobei die Fe³⁺-Ionen-Konzentration im Bereich von 1 bis 100 g/l liegt, die Konzentration der mindestens einen Säure im Bereich von 10 bis 400 g/l liegt und die Konzentration des mindestens einen Ätzadditivs im Bereich von 0,001 bis 10 g/l liegt.

2. Wässrige Zusammensetzung zum Ätzen von Kupfer und Kupferlegierungen nach Anspruch 1, wobei das N-alkoxylierte Polyamid durch N-Alkoxylierung eines Polyamids mit einer oder mehreren Verbindungen der Formel (I), 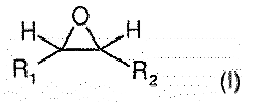 worin R₁ für Wasserstoff oder einen Kohlenwasserstoffrest mit 1 bis 6 Kohlenstoffatomen steht und R₂ für Wasserstoff oder einen Kohlenwasserstoffrest mit 1 bis 6 Kohlenstoffatomen steht,
erhalten wird.

3. Wässrige Zusammensetzung zum Ätzen von Kupfer und Kupferlegierungen nach Anspruch 1, wobei R₁ und R₂ in Formel (I) aus Wasserstoff und Methyl ausgewählt sind.

4. Wässrige Zusammensetzung zum Ätzen von Kupfer und Kupferlegierungen nach Anspruch 1, wobei das N-alkoxylierte Polyamid durch Polymerisation eines N-alkoxylierten Lactams gemäß Formel (2) 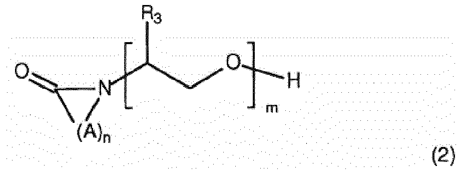 worin R₃ aus der Gruppe bestehend aus Wasserstoff und Methyl ausgewählt ist,
A für einen Kohlenwasserstoffrest steht,
n für eine ganze Zahl von 2 bis 10 steht und m für eine ganze Zahl von 1 bis 50 steht,
erhalten wird.

5. Wässrige Zusammensetzung zum Ätzen von Kupfer und Kupferlegierungen nach Anspruch 4, wobei das N-alkoxylierte Lactam gemäß Formel (2) aus der Gruppe bestehend aus ethoxyliertem beta-Lactam, hexaethoxyliertem gamma-Butyrolactam, octaethoxyliertem delta-Valerolactam, pentapropoxyliertem delta-Valerolactam, hexaethoxyliertem epsilon-Caprolactam und dodecaethoxyliertem epsilon-Caprolactam ausgewählt ist.

6. Wässrige Zusammensetzung zum Ätzen von Kupfer und Kupferlegierungen nach einem der vorhergehenden Ansprüche, wobei die mindestens eine Säure aus der Gruppe umfassend Schwefelsäure und Methansulfonsäure ausgewählt wird.

7. Verfahren zum Ätzen von Kupfer und Kupferlegierungen, bei dem man in der angegebenen Reihenfolge
a. ein Substrat mit einer Kupfer- oder Kupferlegierungsoberfläche bereitstellt,
b. das Substrat in einem ersten Tank mit der wässrigen Zusammensetzung nach einem der Ansprüche 1 bis 9 in Berührung bringt,
wobei während des Inberührungbringens Kupfer zu Cu²⁺-Ionen oxidiert wird und die Cu²⁺-Ionen in der wässrigen Lösung gelöst werden,
c. einen Teil der wässrigen Lösung nach dem Inberührungbringen mit dem Substrat in einem zweiten Tank überführt,
wobei der zweite Tank eine Anode und eine Kathode umfasst, und
d. die Cu²⁺-Ionen durch Anlegen eines Stroms zwischen der Anode und der Kathode zu Kupfer reduziert.

## Revendications

1. Composition aqueuse pour la gravure du cuivre et des alliages de cuivre comprenant des ions Fe³⁺, au moins un acide et au moins un additif de gravure choisi parmi les polyamides N-alcoxylés,
dans laquelle la concentration des ions Fe³⁺ va de 1 à 100 g/l, la concentration de l'au moins un acide va de 10 à 400 g/l et la concentration de l'au moins un additif de gravure va de 0,001 à 10 g/l.

2. Composition aqueuse pour la gravure du cuivre et des alliages de cuivre selon la revendication 1 dans laquelle le polyamide N-alcoxylé est obtenu par N-alcoxylation d'un polyamide avec un ou plusieurs composés de formule (I) 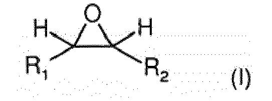 dans laquelle R₁ représente un hydrogène ou un résidu hydrocarboné avec 1 à 6 atomes de carbone et R₂ représente un hydrogène ou un résidu hydrocarboné avec 1 à 6 atomes de carbone.

3. Composition aqueuse pour la gravure du cuivre et des alliages de cuivre selon la revendication 1 dans laquelle R₁ et R₂ dans la formule (I) sont choisis parmi l'hydrogène et le méthyle.

4. Composition aqueuse pour la gravure du cuivre et des alliages de cuivre selon la revendication 1 dans laquelle le polyamide N-alcoxylé est obtenu par polymérisation d'un lactame N-alcoxylé répondant à la formule (2) 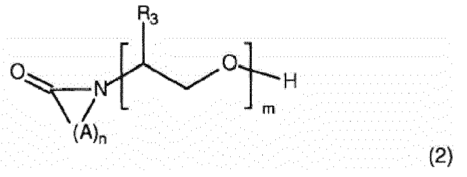 dans laquelle R₃ est choisi dans le groupe constitué par l'hydrogène et le méthyle,
A représente un résidu hydrocarboné,
n est un nombre entier de 2 à 10, et
m est un nombre entier de 1 à 50.

5. Composition aqueuse pour la gravure du cuivre et des alliages de cuivre selon la revendication 4 dans laquelle le lactame N-alcoxylé répondant à la formule (2) est choisi dans le groupe constitué par le bêtalactame éthoxylé, le gamma-butyrolactame hexa-éthoxylé, le delta-valérolactame octa-éthoxylé, le delta-valérolactame penta-éthoxylé, l'epsilon-caprolactame hexa-éthoxylé et l'epsilon-caprolactame dodéca-éthoxylé.

6. Composition aqueuse pour la gravure du cuivre et des alliages de cuivre selon l'une quelconque des revendications précédentes dans laquelle l'au moins un acide est choisi dans le groupe comprenant l'acide sulfurique et l'acide méthanesulfonique.

7. Procédé de gravure du cuivre et des alliages de cuivre comprenant, dans cet ordre, les étapes consistant à
a. se procurer un substrat ayant une surface en cuivre ou alliage de cuivre,
b. mettre ledit substrat en contact avec la composition aqueuse selon l'une quelconque des revendications 1 à 9 dans une première cuve,
le cuivre étant oxydé en ions Cu²⁺ lors de la mise en contact et les ions Cu²⁺ étant dissous dans ladite composition aqueuse,
c. transférer une partie de ladite composition aqueuse après mise en contact avec le substrat dans une deuxième cuve,
ladite deuxième cuve comprenant une anode et une cathode, et
d. réduire lesdits ions Cu²⁺ en cuivre en appliquant un courant entre ladite anode et ladite cathode.
